# EUROPÄISCHE PATENTSCHRIFT

(11) **EP 0 755 521 B1**
(45) Veröffentlichungstag und Bekanntmachung des Hinweises auf die Patenterteilung: **03.12.1997**
(21) Anmeldenummer: 95915774.4
(22) Anmeldetag: 11.04.1995
(51) Int. Cl.: G01R 31/12

(54) **VERFAHREN ZUR ÜBERPRÜFUNG DER FUNKTIONSFÄHIGKEIT EINER ELEKTRISCHEN KRAFTWERKSKOMPONENTE**
PROCESS FOR CHECKING THE EFFICIENCY OF AN ELECTRIC POWER STATION COMPONENT
PROCEDE DE CONTROLE DU FONCTIONNEMENT DE COMPOSANTS ELECTRIQUES D'UNE CENTRALE ELECTRIQUE

(30) Priorität: 15.04.1994 DE 4413110
(43) Veröffentlichungstag der Anmeldung: 29.01.1997
(73) Patentinhaber: SIEMENS AKTIENGESELLSCHAFT, 80333 München (DE)
(72) Erfinder: WOLF, Eckehard, D-91054 Erlangen (DE); WARNKEN, Lüder, D-91052 Erlangen (DE); KLECKA, Frantisek, D-63755 Alzenau (DE); SCHULZ, Hartmut, D-63263 Neu-Isenburg (DE); SIEGLER, Willi, D-63073 Offenbach/Bieber (DE); KNAPP, Anton, D-63791 Karlstein (DE); RICHTER, Barbara, D-91056 Erlangen (DE)
(86) Internationale Anmeldenummer: DE9500498
(87) Internationale Veröffentlichungsnummer: WO9528648

(56) Entgegenhaltungen:
- FR-A- 2 225 819
- GB-A- 1 156 551
- IEEE TRANS. ON POWER APPARATUS & SYST., Bd. pas-99, Nr. 1, Januar 1980 Seiten 46-52, E.A. CHERNEY 'flashover performance'

## Beschreibung

Die Erfindung betrifft ein Verfahren zur Überprüfung der Funktionsfähigkeit einer elektrischen Kraftwerkskomponente, wobei die Oberfläche der Komponente mit einer Prüfflüssigkeit benetzt wird. Dies ist aus dem Dokument FR-A-2 225 819 bekannt.

Im Falle eines Kühlmittelverluststörfalls (KMV-Störfall) kommt es im allgemeinen zu einer starken Dampfproduktion. Das daraufhin anfallende Kondensat benetzt die mit Dampf beaufschlagten Gebäudeteile und Komponenten, insbesondere auch die elektrischen Systeme und die Komponenten der Leittechnik, mit einem feuchten Film. Dieser Film wird durch eine Verbindung der anhaftenden Fremdschichten auf den Komponentenoberflächen leitend. Wenn eine dieser Komponenten durch das benetzende Kondensat in ihrer Funktionsfähigkeit eingeschränkt bzw. zerstört wird, z.B. weil der Isolationswiderstand reduziert wird, so kann dies dazu führen, daß die zur Beherrschung des Störfalls notwendigen Maßnahmen erschwert werden.

Um solche Schäden zu vermeiden, werden alle Komponenten eines Kraftwerks, die im Falle eines KMV-Störfalls von Kondensat benetzt werden konnten, so gebaut, daß sie durch eine Benetzung bei Störfallbedingungen in ihrer Funktionsfähigkeit nicht eingeschränkt werden. Hierzu sind diese Komponenten beispielsweise verkapselt, vergossen oder mit langen Kriechstrecken ausgestattet (sogenannte KMV-Festigkeit).

Da Isolationswerkstoffe in der Regel altern und sich somit die KMV-Festigkeit während der Lebensdauer einer Komponente insbesondere durch Strahlung und den Betriebsbedingungen der Komponente verringern kann, sollte die KMV-Festigkeit betreffender Komponenten mit geeigneten Verfahren überprüft werden.

Der Erfindung liegt die Aufgabe zugrunde, ein zerstörungsfreies Prüfverfahren anzugeben, das eine Aussage über den Zustand relevanter Konstruktionsteile, insbesondere elektrischer und leittechnischer Komponenten einer Kraftwerksanlage, im Hinblick auf ihre KMV-Festigkeit gestattet.

Die auf ein Verfahren gerichtete Aufgabe wird dadurch gelost, daß die Oberfläche einer elektrischen Kraftwerkskomponente mit einer gut benetzenden Prüfflüssigkeit definierter Leitfähigkeit benetzt und an der benetzten Komponente als Wert für deren Funktionsfähigkeit der Isolationswiderstand bestimmt wird. Mit dem Prüfverfahren erfolgt somit eine Benetzung mit einer gut benetzenden Prüfflüssigkeit definierter Leitfähigkeit, wodurch die Benetzung der Komponente durch Kondensat im Falle eines KMV-Störfalls simuliert und als Wert für die Funktionsfähigkeit der Komponente der Isolationswiderstand gemessen wird.

Für diese Überprüfung der Kraftwerkskomponenten kommen vor allem Verfahren der zerstörungsfreien Materialprüfung in Frage, wobei insbesondere durch regelmäßig aufeinander folgende Prüfungen erfaßt und dokumentiert werden kann, wie sich im Lauf der Zeit z.B. elektrische Parameter (Verhalten in hochfrequenten Wechselfeldern, Kapazität, Ausbildung und Dämpfung von Wirbelströmen etc.) ändern. Als einfachste und aussagekräftigste Maßnahme kann eine Prüfung der Isolation bzw. des elektrischen Übergangswiderstandes zwischen einzelnen spannungsführenden Teilen der Kraftwerkskomponente vorgenommen werden.

Da dieses Prüfverfahren keine Störfallbedingungen erfordert, kann es während des normalen Betriebes einer Kraftwerksanlage vorgenommen werden. Vorzugsweise erfolgt eine Überprüfung der Funktionsfähigkeit der Kraftwerkskomponente bei einer Temperatur zwischen 15° C und 35° C. Bevorzugt ist hierbei der für die Funktionsfähigkeit relevante Parameter der Isolationswiderstand der Komponente, welcher mittels des Verfahrens bestimmt wird. Beispielsweise kann für einen Motorantrieb zum Zweck der Bestimmung der Funktionsfähigkeit in einer Meßreihe jeweils der Übergangswiderstand zwischen einer Anschlußklemme einer Motorwicklung und dem nicht mit der Wicklung galvanisch verbundenen Massenanschluß durch ein aktives Widerstandsmeßgerät (z.B. eine Spannungsquelle bei der Ausgangsstrom und Ausgangsspannung erfaßt werden) unter den normalen Raumbedingungen gemessen werden. Typische Meßwerte liegen z.B. zwischen 4,5 und 9,0 x 10⁶ Ω. Die Messungen an den gleichen Klemmen ergeben unter den Bedingungen eines Kühlmittelverlust-Störfalls (erhöhter Druck, erhöhte Temperatur, Benetzung) Meßwerte von 10⁴ Ω. Der maximale Einfluß dieser verschärften Bedingungen bei einem Störfall kann für jede einzelne Komponente mit einem sicheren Grenzwert bestimmt werden, insbesondere durch das Verhältnis der niedrigsten Werte bei den verschärften Störfall-Bedingungen zu den höchsten Widerstandswerten bei Normalbedingungen. Die sich hieraus ergebenden Werte werden als Umrechnungsfaktor Q genutzt, um von Prüf- auf Störfallbedingungen umrechnen zu können, welcher typischerweise zwischen 10⁻² bis 10⁻³ liegt.

Die Funktion von Komponenten mit Ableitstromfluß über ihre Isolatoroberflächen wird beeinflußt durch anhaftende Fremdschichten. Das Verfahren zur Überprüfung der Funktionsfähigkeit berücksichtigt auch den Einfluß derartiger Fremdschichten, die im Störfall vom Kondensat des Kühlmittels befeuchtet werden. Beispielsweise tritt bei einem Riß im Kühlmittelsystem eines mit Leichtwasser gefüllten Kernreaktors das unter hohem Druck stehende Kühlmittel (Wasser) mit der erhöhten Betriebstemperatur aus und verdampft. Dieser Wasserdampf kondensiert auch an den verschiedenen zur Störfallbeherrschung erforderlichen elektrischen und leittechnischen Komponenten. Die Verbindung von Kondensat und Fremdschicht kann durch ihre Leitfähigkeit zu Kurzschlüssen in der Stromversorgung, zu Fehlsignalen oder Signalausfällen und anderen Fehlern führen, die die Funktionsfähigkeit dieser Komponenten und damit der gesamten Einrichtungen zur Störfallbeherrschung stören. Eine Beeinträchtigung der Funktionsfähigkeit kann zudem durch den Druck des verdampfenden Kühlmittels gefördert werden.

Mit dem Verfahren wird insbesondere die Funktionsfähigkeit der sicherheitsrelevanten Komponenten überprüft, insbesondere wird diese Überprüfung in zeitlichen Abständen wiederholt. Hierdurch kann die Möglichkeit sich anbahnender oben geschilderter Funktionsstörungen rechtzeitig erkannt und geeignete Gegenmaßnahmen, z.B. Auswechseln der gefährdeten Komponenten, ergriffen werden. Da die Überprüfung während des normalen Betriebs oder den normalen Stillstandszeiten der Kraftwerksanlage bei Raumtemperatur erfolgt, stellt das Verfahren eine effektive und sichere Maßnahme zur Erhöhung der Sicherheit einer Kernkraftanlage dar. Durch eine in gegebenenfalls regelmäßigen Abständen durchgeführte Überprüfung der Kraftwerkskomponenten können Komponenten, deren Kühlmittelverlust-Festigkeit sich im Laufe der Zeit verringert, rechtzeitig ausgetauscht oder ertüchtigt werden.

Für die Reproduzierbarkeit vorgenannten Messungen ist eine gute Benetzung der Oberfläche erforderlich, was durch eine Verwendung entsprechender Prüfflüssigkeit mit hinreichenden Benetzungseigenschaften erreicht wird.

Eine erste Alternative für eine hinreichende Benetzung der Oberfläche der Komponente besteht darin, einen Film möglichst gleichmäßiger und reproduzierbarer Dicke einer Prüfflüssigkeit auf die Oberfläche aufzubringen. Dies erfolgt vorzugsweise dadurch, daß die Prüfflüssigkeit auf die Oberfläche aufgesprüht wird. Dies kann bei normalem Atmosphärendruck, insbesondere etwa 100 kP, durchgeführt werden. Die Komponente kann dabei in ihrem eingebauten Zustand belassen werden. Gegebenenfalls kann es günstig sein, eine Komponente, insbesondere wenn diese einfach ausbaubar ist, auszubauen und die Prüfung an einem anderen Ort durchzuführen. Eine Durchführung des Verfahrens ist somit während des Betriebes der Kraftwerksanlage ohne zusätzlichen Aufwand einfach möglich. Zur Gewährleistung einer guten Reproduzierbarkeit ist es günstig, eine den für die Funktionsfähigkeit relevanten Parameter, nämlich den Isolationswiderstand bestimmende Größe, beispielsweise einen elektrischen Strom, einen elektrischen Widerstand oder eine elektrische Spannung, etwa 60 s nach Aufsprühen der Prüfflüssigkeit zu messen. Nach etwa 60 s hat sich in der Regel ein Film ausreichender Gleichmäßigkeit über die Komponente verbreitet, so daß die Reproduzierbarkeit der Messung gewährleistet ist. Vorzugsweise erfolgt das Besprühen, eine sogennante Sprühprüfung, bei Komponenten mit nicht hygroskopischem und weitgehend druckfestem Isolatormaterial.

Eine weitere Durchführungsart des Verfahrens besteht darin, eine Kraftwerkskomponente in die Prüfflüssigkeit einzutauchen. Die Prüfflüssigkeit steht hierzu vorzugsweise unter einem Überdruck von mehr als 500 kPa, insbesondere etwa 650 kPa. Diese Durchführungsart des Verfahrens wird daher auch als Tauchdruckprüfung bezeichnet. Durch das Eintauchen der Komponente in die Prüfflüssigkeit wird die Komponente mit der Prüfflüssigkeit benetzt, so daß vorzugsweise eine den Isolationswiderstand bestimmende Größe etwa 120 s nach Herausnehmen der Komponente aus der Prüfflüssigkeit gemessen wird. Die Dauer des Eintauchens unter Druck wird dabei durch den zu beherrschenden Störfallverlauf bestimmt. Wenn der zeitliche Verlauf des zu überwachenden Isolationswiderstandes auch während des Eintauchens bestimmt werden kann, ist es möglich, die Prüfung bereits bei Erreichen eines Mindestwertes abzubrechen und dadurch gegebenenfalls die Prüfdauer zu vekürzen. Die Tauchdruckprüfung wird vorzugsweise bei einer Kraftwerkskomponente mit einem hygroskopischen und/oder unter Druck verformbaren Isolatormaterial, von dem sie umgeben ist, durchgeführt.

Als Prüfflüssigkeit wird vorzugsweise eine ionenfreie Flüssigkeit, in der ein Benetzungsmittel gelöst wird, verwendet. Hierdurch wird die Tatsache berücksichtigt, daß in einem Kühlsystem einer Kernkraftanlage hochreines, entionisiertes Wasser enthalten ist, dem gegebenenfalls eine geringe Menge, maximal 2200 ppm, Bor zugesetzt ist. In einem Kühlmittelverlust-Störfall einer Kernkraftanlage kann das entstehende Kondensat zusätzlich noch Bor (etwa 20 ppm) enthalten, was die Leitfähigkeit des reinen Wassers (ca. 2,5 µS/cm) nur unwesentlich (um ca. 0,3 µS/cm) heraufsetzt. Vorteilhaft ist zudem, daß eine solche Prüfflüssigkeit, eine wäßrige Lösung mit Benetzungsmittel, die Oberfläche der Kraftwerkskomponente nicht angreift, wodurch die Funktionsfähigkeit der Komponente gewährleistet bleibt und eine nahezu beliebige Wiederholung der zerstörungsfreien Überprüfung der Funktionsfähigkeit möglich ist.

Vorzugsweise hat die Prüfflüssigkeit eine Oberflächenspannung und eine Leitfähigkeit, die es erlaubt, die Einflüsse des Kühlmittelkondensats nachzubilden. Die Leitfähigkeit und die Oberflächenspannung der Prüfflüssigkeit bei der Temperatur der Messung sind daher vorteilhaft etwa gleich der Leitfähigkeit und der Oberflächenspannung des anfallenden Kondensats in einem Kühlmittelverlust-Störfall. Eine Fremdschicht auf der getesteten Oberfläche wirkt dann also genau so, wie eine entsprechende Fremdschicht in einem realen Kühlmittelverlust-Störfall wirken würde. Insbesondere hat die verwendete Prüfflüssigkeit in einem Temperaturbereich von 15° C bis 35° C die erforderliche Leitfähigkeit und Oberflächenspannung. Vorzugsweise ist die Oberflächenspannung der Prüfflüssigkeit in dem Temperaturbereich von 15° C bis 35° C, also im Bereich normaler Raumtemperatur, praktisch temperaturunabhängig. Eine Überprüfung der Funktionsfähigkeit erfordert daher keine besondere Temperierung der Komponenten und ihrer Umgebung. Vorteilhafterweise enthält die Prüfflüssigkeit gesundheitsschädliche Bestandteile bzw. Wirkstoffe nur in einer unbedenklichen Konzentration, so daß sie leicht zu handhaben und zu entsorgen ist.

Die Herstellung einer solchen Prüfflüssigkeit kann z.B. durch Vedünnung eines praktisch nicht-ionischen Benetzungsmittels mit weitgehend entionisiertem Wasser erfolgen. Die Benetzungsmittelkonzentration kann in weiten Toleranzgrenzen eingestellt werden, ohne die Reproduzierbarkeit der Überprüfung zu storen. Dies hat den Vorteil, daß die Prüfflüssigkeit an allen Kraftwerksanlagen durch Verdünnen eines Konzentrats, das dort auf Vorrat bereitgehalten werden kann, leicht herstellbar ist. Nach Durchführung des Verfahrens kann die Komponente mit einem Spülmedium, welches insbesondere ebenfalls entionisiertes Wasser ist, an ihrer Oberfläche von den Spuren der Prüfflüssigkeit, und damit auch von Schmutz gereinigt werden. Somit hat die Durchführung des Verfahrens zur Überprüfung der Funktionsfähigkeit zusätzlich noch die vorteilhafte Nebenwirkung, daß die Komponenten gereinigt werden und somit die Isolationsfähigkeit der Komponente im Falle eines Kühlmittelverlust-Störfalls erhöht ist. Als Benetzungsmittel der Prüfflüssigkeit eignen sich besonders Polyglycoläther, insbesondere mit einem Gehalt von 0,1 +/- 0,05 Gew.-% eines Polyglycoläthers der allgemeinen Formel R-CH₂-O(CH₂CH₂O)ₙH, wobei R ein Rest eines Fettalkohols mit der mittleren Kettenlänge von 13 C-Atomen ist und n zwischen 5 und etwa 15 liegt. Die Benetzungswirkung steigt mit zunehmendem Äthylenoxid an, erreicht bei n = 8 ein Optimum und fällt mit weiter steigendem n wieder leicht ab. Als besonders vorteilhaftes Benetzungsmittel wird also R-CH₂-O(CH₂CH₂O)₈H verwendet, das vor allem im niedrigen Temperaturbereich ein besonders gut ausgeprägtes Benetzungsvermögen besitzt und zudem sehr gut wasserlöslich ist.

Die Erfindung zeichnet sich durch ein Verfahren zur Überprüfung der Funktionsfähigkeit einer elektrischen oder leittechnischen Komponente einer Kraftwerksanlage aus, welches während des normalen Betriebes oder der normalen Stillstandszeiten der Kraftwerksanlage auch bei normalen Betriebsbedingungen durchgeführt wird. Das Verfahren kann bei Normaldruck und bei Betriebstemperatur der Komponente zerstörungsfrei durch geführt werden und erlaubt durch Messung bei Normalbedingungen Rückschlüsse auf die Funktionsfähigkeit der Komponente in einem Störfall, bei welchem viel höhere Temperaturen, größerer Druck und höhere Feuchtigkeit als bei der Durchführung des Verfahrens herrschen. Diese Rückschlüsse werden beispielsweise dadurch möglich, daß vor der Durchführung des Verfahrens eine hinreichend reproduzierbare Beziehung zwischen dem gemessenen Isolationswiderstand unter Störfallbedingungen und dem gemessenen Isolationswiderstand unter Normalbedingungen ermittelt, insbesondere für jede einzelne Komponente, und anhand dieser Beziehung die gemessenen Werte auf die Werte, die im Störfall aufträten, umgerechnet werden. Durch eine zerstörungsfreie Überprüfung der entsprechenden Komponenten in gegebenenfalls regelmäßigen Zeitabständen kann die zeitliche Entwicklung der Funktionsfähigkeit jeder Komponente bestimmt und die entsprechenden Meßdaten gespeichert werden, so daß frühzeitig eine sich anbahnende Verminderung der Funktionsfähigkeit unter Störfallbedingungen erkannt und entsprechende Gegenmaßnahmen eingeleitet werden können. Wenn die gespeicherten Meßdaten bei aufeinanderfolgenden Kontrollmessungen z.B. deutlich abfallende Widerstandswerte ergeben, also auf eine drohende Funktionsunfähigkeit der untersuchten Komponente hinweisen, kann diese Komponente ausgetauscht oder ertüchtigt werden. Das Verfahren und die damit eingeleiteten Gegenmaßnahmen bewirken daher, ohne eine Beeinträchtigung des normalen Betriebs einer Kraftwerksanlage eine Erhöhung der Sicherheit dieser Anlage, was insbesondere bei einer Kernkraftanlage von entscheidendem Vorteil ist.

## Patentansprüche

1. Verfahren zur zerstörungsfreien Überprüfung der Funktionsfähigkeit wenigstens einer elektrischen Kraftwerkskomponente im Fall einer Benetzung mit einem Fluid, insbesondere mit in einem Störfall austretendem Kühlmittel, bei dem die Oberfläche der Komponente mit einer gut benetzenden Prüfflüssigkeit definierter Leitfähigkeit benetzt und an der benetzten Komponente als Wert für deren Funktionsfähigkeit der Isolationswiderstand gemessen wird.

2. Verfahren nach Anspruch 1, welches bei einer Temperatur zwischen 15°C und 35°C durchgeführt wird.

3. Verfahren nach einem der vorhergehenden Ansprüche, bei dem aus einem Meßwert oder mehreren Meßwerten einer den Isolationswiderstand bestimmenden Größe ein erster Wert bestimmt wird, den der Isolationswiderstand unter den Bedingungen eines Störfalls mit austretendem Kühlmittel annähme.

4. Verfahren nach Anspruch 3, bei dem der erste Wert als Produkt aus einem unter den Bedingungen der Prüfung bestimmten zweiten Wert des Isolationswiderstandes und einem Faktor Q berechnet wird, wobei der Faktor Q aus Vergleichs experimenten für die zu untersuchende Komponente ermittelt wird.

5. Verfahren nach einem der vorhergehenden Ansprüche, wobei die Oberfläche von einem Film der Prüfflüssigkeit möglichst gleichmäßiger und reproduzierbarer Dicke benetzt wird.

6. Verfahren nach einem der vorhergehenden Ansprüche, bei dem die Prüfflüssigkeit aufgesprüht wird.

7. Verfahren nach Anspruch 6, welches bei normalem Atmosphärendruck, insbesondere etwa 100 kPa, durchgeführt wird.

8. Verfahren nach einem der Ansprüche 6 oder 7, welches an einer Komponente im eingebauten Zustand durchgeführt wird.

9. Verfahren nach einem der Ansprüche 6 bis 8, bei dem eine den Parameter bestimmende Größe etwa 60 sec nach Aufsprühen der Prüfflüssigkeit gemessen wird.

10. Verfahren nach einem der Ansprüche 6 bis 9 an einer Komponente mit nicht hygroskopischem und weitgehend druckfestem Isolatormaterial.

11. Verfahren nach einem der Ansprüche 1 bis 5, bei dem die Komponente in die Prüfflüssigkeit eingetaucht wird.

12. Verfahren nach Anspruch 11, bei dem die Prüfflüssigkeit einem Überdruck von mehr als 500 kPa, insbesondere etwa 650 kPa, ausgesetzt wird.

13. Verfahren nach einem der Ansprüche 11 oder 12, bei dem eine den Parameter bestimmenden Größe etwa 120 sec nach Herausnehmen der Komponente aus der Prüfflüssigkeit gemessen wird.

14. Verfahren nach einem der Ansprüche 11 bis 13 an einer Komponente mit hygroskopischem und/oder unter Druck verformbaren Isolatormaterial.

15. Verfahren nach einem der vorhergehenden Ansprüche, bei dem die Prüfung der Funktionsfähigkeit in zeitlichen Abständen wiederholt und aus jeweiligen bestimmten Werte des Isolationswiderstandes eine zeitliche Entwicklung der Funktionsfähigkeit ermittelt wird.

16. Verfahren nach einem der vorhergehenden Ansprüche, bei dem eine weitgehend ionenfreie Prüfflüssigkeit, in der ein Benetzungsmittel gelöst ist, verwendet wird.

## Claims

1. Process for the non-destructive testing of the functioning of at least one electrical power station component being wetted with a fluid, in particular a coolant escaped in an accident, in which the surface of the component is wetted with a highly wetting test fluid of defined conductivity, and insulation resistance is measured at the wetted component as a value for the functioning of the component.

2. Process according to claim 1, which is performed at a temperature between 15°C and 35°C.

3. Process according one of the preceding claims, in which a first value that the insulation resistance would assume under conditions of an accident with an escape of coolant, is determined from at least one measured value of a variable determining the insulation resistance.

4. Process according to claim 3, in which the first value is calculated as a product of a second value of the insulation resistance determined under test conditions and a factor Q, wherein the factor Q is determined from comparison experiments for the component to be investigated.

5. Process according to one of the preceding claims, in which the surface is wetted with a film of the test fluid of the most uniform and replicable possible thickness.

6. Process according to one of the preceding claims, in which the test fluid is sprayed on.

7. Process according to claim 6, which is performed at normal atmospheric pressure, in particular at approximately 100 kPa.

8. Process according to claim 6 or 7, which is performed on an installed component.

9. Process according to one of claims 6 to 8, in which a variable determining the parameter is measured approximately 60 seconds after the test fluid is sprayed on.

10. Process according to one of claims 6 to 9, on a component having non-hygroscopic and largely pressure-proof insulator material.

11. Process according to one of claims 1 to 5, in which the component is dipped into the test fluid.

12. Process according to claim 11, in which the test fluid is subjected to an overpressure of more than 500 kPa, in particular approximately 650 kPa.

13. Process according to claim 11 or 12, in which a variable determining the parameter is measured approximately 120 seconds after the component is removed from the test fluid.

14. Process according to one of claims 11 to 13, on a component with hygroscopic insulator material and/or insulator material being deformable under pressure.

15. Process according to one of the preceding claims, in which the testing of the function is repeated at time intervals, and a development in the function over time is determined from respective determined values of the insulation resistance.

16. Process according to one of the preceding claims, in which there is used a largely ion-free test fluid in which a wetting agent is dissolved.

## Revendications

1. Procédé de contrôle non destructif de l'aptitude à fonctionner d'au moins un composant électrique d'une centrale électrique dans le cas d'une humidification par un fluide notamment par un fluide de refroidissement sortant lors d'un incident, dans lequel on humidifie la surface du composant par un fluide d'essai humidifiant bien et de conductivité définie et dans lequel on mesure la résistance d'isolation sur le composant humidifié en tant que valeur pour son aptitude à fonctionner.

2. Procédé suivant la revendication 1, que l'on met en oeuvre à une température comprise en 15°C et 35°C.

3. Procédé suivant l'une des revendications précédentes, dans lequel on détermine à partir d'une valeur de mesure ou de plusieurs valeurs de mesure d'une grandeur déterminant la résistance d'isolation une première valeur, que prendrait la résistance d'isolation dans les conditions d'un incident où le fluide de refroidissement sortirait.

4. Procédé suivant la revendication 3, dans lequel on calcule la première valeur en tant que produit d'une seconde valeur de la résistance d'isolation déterminée dans les conditions de l'essai et d'un facteur Q, le facteur Q étant déterminé par des expériences de comparaison pour le composant à examiner.

5. Procédé suivant l'une des revendications précédentes, dans lequel on humidifie la surface par un film du fluide d'essai d'épaisseur la plus uniforme et la mieux reproductible possible.

6. Procédé suivant l'une des revendications précédentes, dans lequel on asperge le fluide d'essai.

7. Procédé suivant la revendication 6, qui est mis en oeuvre à pression atmosphérique normale, notamment à environ 100 kPa.

8. Procédé suivant l'une des revendications 6 ou 7, qui est mis en oeuvre sur un composant à l'état monté.

9. Procédé suivant l'une des revendications 6 à 8, dans lequel on mesure une grandeur déterminant le paramètre à peu près 60 s après l'aspersion du fluide d'essai.

10. Procédé suivant l'une des revendications 6 à 9 mis en oeuvre sur un composant ayant un matériau d'isolateur non hygroscopique et résistant dans une large mesure à la pression.

11. Procédé suivant l'une des revendications 1 à 5, dans lequel on immerge le composant dans le fluide d'essai.

12. Procédé suivant la revendication 11, dans lequel on soumet le fluide d'essai à une surpression de plus de 500 kPa, notamment d'environ 650 kPa.

13. Procédé suivant l'une des revendications 11 ou 12, dans lequel on mesure une grandeur déterminant le paramètre à peu près 120 s après avoir retiré le composant du fluide d'essai.

14. Procédé suivant l'une des revendications 11 à 13 mis en oeuvre sur un composant à matériau d'isolateur hygroscopique et/ou pouvant être déformé sous pression.

15. Procédé suivant l'une des revendications précédentes, dans lequel on répète l'essai de l'aptitude au fonctionnement dans des intervalles de temps et on détermine une évolution dans le temps de l'aptitude au fonctionnement à partir de valeurs déterminées de la résistance d'isolation.

16. Procédé suivant l'une des revendications précédentes, dans lequel on utilise un fluide d'essai sans ion dans une large mesure, dans lequel un agent mouillant est dissout.
